# EUROPEAN PATENT APPLICATION

(11) **EP 4 667 992 A1**
(43) Date of publication of application: **24.12.2025**
(21) Application number: 25183955.1
(22) Date of filing: 19.06.2025
(51) Int. Cl.: G02B 7/00, G02B 27/01

(54) **HEAD MOUNTED DISPLAY DEVICE**

(30) Priority: 20.06.2024 KR 20240080179; 08.10.2024 KR 20240136934
(71) Applicant: Samsung Display Co., Ltd., Yongin-si, Gyeonggi-do 17113 (KR)
(72) Inventor: HWANG, Sang Ho, 17113 Yongin-si (KR); SON, Jun Hee, 17113 Yongin-si (KR); KIM, Sung Hoon, 17113 Yongin-si (KR); KIM, Seung Ho, 17113 Yongin-si (KR); PARK, Haeng Won, 17113 Yongin-si (KR); BAE, Hyun Chul, 17113 Yongin-si (KR)
(74) Representative: Walaski, Jan Filip

(57) **Abstract**

A head mounted display device is disclosed that includes a display panel, and a heat exchanger attached to a back surface of the display panel to transfer heat away from the display panel. The heat exchanger includes a center portion, and a plurality of wings bent from the center portion.

## Description

This application claims priority to Korean Patent Application No. 10-2024-0080179 filed on 20 June 2024 and 10-2024-0136934 filed on 8 October 2024.

### BACKGROUND

### 1. Field

The present disclosure relates to a head mounted display device, and more particularly, to a head mounted display device having an efficient heat dissipation structure.

### 2. Description of the Related Art

Recently, a head mounted display device (HMD) has been developed as a display device that is mounted on a head of a user to view images. The HMD may have an optical unit for each of left and right eyes, and may be configured to control vision and hearing in combination with a headphone. If the HMD completely blocks out the outside world when mounted on a user's head, the HMD may provide virtual reality to the user.

An HMD display panel may include, for example, a liquid crystal, an organic electro-luminescence (EL) element, or the like. Since the HMD is mounted on the head of the user, the HMD operates close to the user's eyes. Recently, various methods for heat dissipation of the display panel of the HMD have been studied.

The content described above is only intended to help understanding of the background technology of the technical ideas of the disclosure, and thus it cannot be understood as content corresponding to prior art known to those skilled in the art of the technical field of the disclosure.

### SUMMARY

Embodiments of the disclosure may provide a head mounted display device capable of efficiently transferring heat generated when a display panel.

According to embodiments of the disclosure, a head mounted display device includes a display panel, and a heat exchanger attached to a back surface of the display panel to transfer heat away from the display panel. The heat exchanger includes a center portion, and a plurality of wings bent from the center portion.

The head mounted display device may display an image through a front surface of the display panel opposite to the back surface of the display panel.

An internal space of the center portion and the plurality of wings may include a heat pipe, and a working fluid within the heat pipe that, in operation, transfers heat away from the display panel.

The working fluid may include a liquid and an air layer.

A volume of the liquid in the working fluid may be 20% or more and 50% or less.

The liquid may include at least one of water, freon, methanol, and ethanol.

The display panel may be attached to the center portion.

The display panel may be attached to one of the plurality of wings.

The heat exchanger may include three wings bent from the center portion, and the three wings may extend from different edges of the center portion, respectively.

The heat pipe disposed in the internal space of the center portion and the three wings may be connected to each other to form a loop.

Heat pipes disposed in the internal space of each of the three wings may be separated from each other to form separate closed loops.

Volumes of liquid in the working fluid included in each of the separate closed loops may be different from each other.

The heat exchanger may include four wings bent from the center portion, and the four wings may extend from different edges of the center portion, respectively.

The heat pipe disposed in the internal space of the center portion and the four wings may be connected to each other to form a closed loop.

Heat pipes disposed in the internal space of each of the four wings are separated from each other to form separate closed loops.

Volumes of liquid in the working fluid included in each of the separate closed loops may be different from each other.

Angles formed by the center portion and each of the plurality of wings may be different from each other.

According to embodiments of the disclosure, a head mounted display device capable of efficiently releasing heat generated when a display panel is driven to an outside may be provided.

However, an effect of the disclosure is not limited to that described above, and may be expanded variously without departing from the spirit and scope of the disclosure.

### BRIEF DESCRIPTION OF THE DRAWINGS

The above and other features of the disclosure will become more apparent by describing in further detail embodiments thereof with reference to the accompanying drawings, in which:
FIG. 1 is a block diagram of a head mounted display device;
FIG. 2 is a drawing illustrating a head mounted display device;
FIG. 3 is a block diagram illustrating an embodiment of a display module of FIG. 1;
FIG. 4 is a schematic cross-sectional view taken along line I-I' of FIG. 2;
FIG. 5 is a drawing illustrating a heat dissipation effect of the head mounted display device of FIG. 4;
FIG. 6 is a perspective view illustrating an embodiment of a heat exchanger of FIG. 4;
FIG. 7 is an un-folded plan view illustrating an embodiment of an internal configuration of the heat exchanger of FIG. 6;
FIG. 8 is an enlarged view of a portion X of FIG. 7;
FIG. 9 is a drawing illustrating a heat dissipation effect of the heat exchanger of FIG. 7;
FIG. 10 is a perspective view illustrating an embodiment of the heat exchanger of FIG. 4;
FIG. 11 is an un-folded plan view illustrating an embodiment of an internal configuration of the heat exchanger of FIG. 10;
FIG. 12 is a drawing illustrating a heat dissipation effect of the heat exchanger of FIG. 11;
FIG. 13 is a perspective view illustrating an embodiment of the heat exchanger of FIG. 4;
FIG. 14 is an un-folded plan view illustrating an embodiment of an internal configuration of the heat exchanger of FIG. 13;
FIG. 15 is a drawing illustrating a heat dissipation effect of the heat exchanger of FIG. 14;
FIG. 16 is a perspective view illustrating an embodiment of the heat exchanger of FIG. 4;
FIG. 17 is an un-folded plan view illustrating an embodiment of an internal configuration of the heat exchanger of FIG. 16; and
FIG. 18 is a drawing illustrating a heat dissipation effect of the heat exchanger of FIG. 17.

### DETAILED DESCRIPTION

Hereinafter, embodiments are described with reference to the accompanying drawings. It should be noted that in the following description, portions for understanding structure and operation according to the disclosure are described, and descriptions of other portions may be omitted in order not to obscure the subject matter of the disclosure. In addition, the disclosure may be embodied in other forms without being limited to the embodiments described herein. However, the embodiments described herein are provided to describe and implement the technical spirit of the disclosure to those skilled in the art to which the disclosure belongs.

Throughout the specification, in a case where a portion is "connected" to another portion, the case includes not only a case where the portion is "directly connected" but also a case where the portion is "indirectly connected" with another element interposed therebetween. Terms used herein are for describing specific embodiments and are not intended to limit the disclosure. It will be further understood that the terms "comprises" and "includes" (as well as variations such as "including") when used in this specification, specify the presence of stated features, integers, steps, operations, elements, or components, but do not preclude the presence or addition of one or more other features, integers, steps, operations, elements, components, or groups thereof. "At least any one of X, Y, and Z" and "at least any one selected from a group consisting of X, Y, and Z" may be interpreted as one X, one Y, one Z, or any combination of two or more of X, Y, and Z (for example, XYZ, XY, YZ, and ZZ).

Here, terms such as first and second may be used to describe various components, but these components are not limited to these terms. These terms are used to distinguish one component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and thus the spatially relative terms used herein are interpreted according thereto.

Various embodiments are described with reference to drawings schematically illustrating the embodiments. Accordingly, it will be expected that shapes may vary, for example, according to tolerances or manufacturing techniques. Therefore, the embodiments disclosed herein are not to be construed as being limited to shown specific shapes, and should be interpreted as including, for example, changes in shapes that occur as a result of manufacturing. As described above, the shapes shown in the drawings may not show actual shapes of areas of a device, and the present embodiments are not limited thereto.

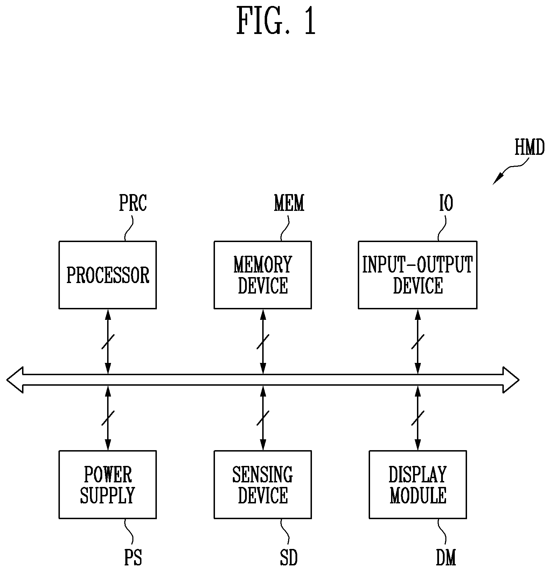

FIG. 1 is a block diagram illustrating a head mounted display device.

Referring to FIG. 1, the head mounted display device (HMD) may include a processor PRC, a memory device MEM, an input/output device IO, a power supply PS, a sensing device SD, and a display module DM. Components of the head mounted display device HMD are not limited to FIG. 1, and may have more or fewer components than the components shown in FIG. 1.

The processor PRC may perform specific calculations or tasks. The processor PRC may control overall operations of the head mounted display device HMD. The processor PRC may process a signal, data information, and the like input through the input/output device IO, or may provide or process appropriate information or function to a user by driving an application program stored in the memory device MEM. The processor PRC may be a microprocessor, a central processing unit (CPU), an application processor (AP), a communication processor (CP), or the like. The processor PRC may be connected to other components through an address bus, a control bus, a data bus, and the like. In addition, the processor PRC may be connected to an expansion bus such as a peripheral component interconnect (PCI) bus.

The memory device MEM may store data necessary for an operation of an electronic device. The memory device MEM may store a plurality of application programs driven in the head mounted display device HMD, data for an operation of the head mounted display device HMD, commands, and the like. At least a portion of these application programs may be downloaded from an external server through the input/output device IO. In addition, for example, the memory device MEM may include a nonvolatile memory device such as an EPROM, an EEPROM, a flash memory, a phase change random access memory (PRAM), a resistance random access memory (RRAM), a magnetic random access memory (MRAM), a ferroelectric random access memory (FRAM), or a volatile memory device such as a dynamic random access memory (DRAM), a static random access memory (SRAM), a mobile DRAM.

The input/output device IO may include an input means including a camera or an image input unit for inputting an image signal, a microphone or an audio input unit for inputting an audio signal, a user input unit (for example, a touch key, a push key, a joystick, a wheel key, and the like) for receiving information from a user, and an output means including an audio output unit, a haptic module, an optical output unit, and the like for generating an output related to vision, hearing, or tactile sensation. The display module DM may be provided in the input/output device IO.

The power supply PS may supply power required for the operation of the head mounted display device HMD. The power supply PS may receive external power and internal power and supply power to each of the components included in the head mounted display device HMD. The power supply PS may include a battery and may be implemented as a built-in battery or a replaceable battery.

The sensing device SD may include at least one sensor for sensing environmental information surrounding the head mounted display device HMD, user information, and the like. For example, the sensing device SD may include a speed sensor, an acceleration sensor, a gravity sensor, an illuminance sensor, a motion sensor, a fingerprint recognition sensor, a light sensor, an ultrasonic sensor, a heat sensing sensor, and the like.

The display module DM may be connected to other components through the above-described buses or another communication link. The display module DM may display information processed in the head mounted display device HMD.

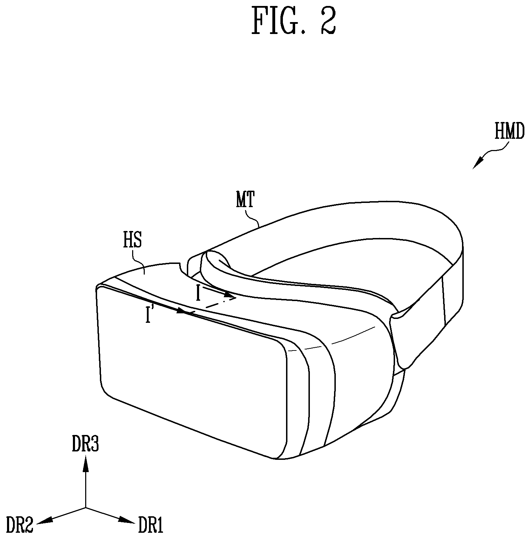

FIG. 2 is a drawing illustrating a head mounted display device.

Referring to FIGS. 1 and 2, the head mounted display device HMD may include a housing HS and a mount unit MT. The head mounted display device HMD may be mounted on the head of the user to provide image information to the user.

The housing HS may be positioned in front of the user's eyes. Components for operating the head mounted display device HMD (for example, the processor PRC, the memory device MEM, the input/output device IO, the power supply PS, the sensing device SD, and the display module DM) may be located in the housing HS. In addition, a wireless communication unit, an interface unit, and the like may be additionally positioned in the housing HS. The wireless communication unit may perform wireless communication with an external terminal to receive an image signal from an external terminal. For example, the wireless communication unit may communicate with the external terminal using Bluetooth, radio frequency identification (RFID), infrared data association (IrDA), ZigBee, near field communication (NFC), wireless-fidelity (Wi-Fi), ultra wideband (UWB), or the like. The interface unit may connect the head mounted display device HMD to the external device. For example, the interface unit of the head mounted display device may include at least one of a wired/wireless headset port, an external charger port, a wired/wireless data port, a memory card port, a port for connecting a device equipped with an identification module, an audio input/output (I/O) port, a video I/O port, and an earphone port.

The display module DM may provide an image to each of left and right eyes of the user. A left-eye image corresponding to the left eye of the user and a right-eye image corresponding to the right eye of the user may be the same or different. The head mounted display device HMD may provide 2D, 3D, virtual reality, 360-degree panoramic images, and the like through the display module DM. The display module DM may include at least one of a liquid crystal display (LCD), an organic light emitting display (OLED), an inorganic light emitting display, and a flexible display. In FIG. 2, the display module DM is shown as being built into the housing HS, but it is not necessarily limited thereto. For example, the display module DM may be coupled with the housing HS. The display module DM may receive an instruction through the interface unit provided in the housing HS.

The mount unit MT may be connected to the housing HS to fix the head mounted display device HMD to the user's head. For example, the mount unit MT may be implemented as a belt, an elastic band, or the like.

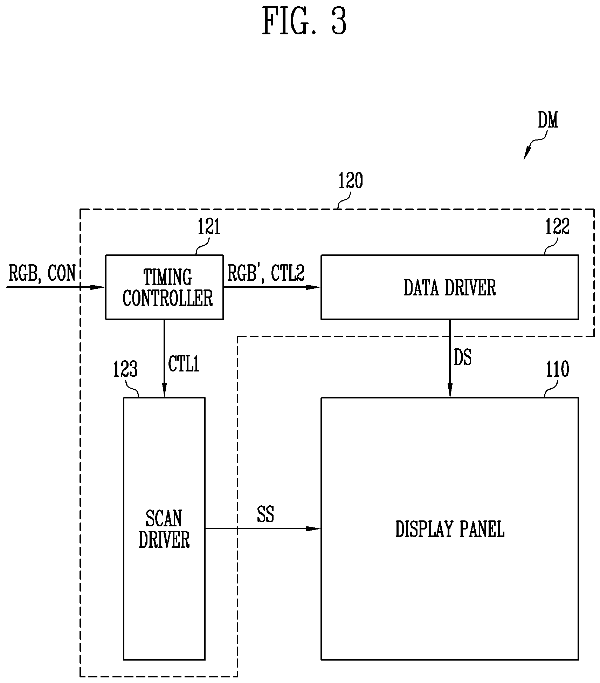

FIG. 3 is a block diagram illustrating the display module of FIG. 1.

Referring to FIG. 3, the display module DM of the head mounted display device HMD may include a display panel 110 and a set (or control circuit) 120. The set 120 may include a timing controller 121, a data driver 122, and a scan driver 123.

The display panel 110 may display an image based on a data signal DS. The display panel 110 may include data lines, scan lines, and a plurality of pixels. For example, each of the pixels included in the display panel 110 may include a thin film transistor electrically connected to the data line and the scan line, a storage capacitor connected to the thin film transistor, a driving transistor (thin film transistor) connected to the storage capacitor, and a light emitting element connected to the driving transistor.

The timing controller 121 may receive image data RGB and a control signal CON from an external terminal (for example, the processor PRC (refer to FIG. 1).

The timing controller 121 may selectively perform image quality correction, adaptive color correction (ACC), dynamic capacitance compensation (DCC) or the like on the image data RGB supplied from the external terminal (for example, the processor PRC) and output image data RGB' to the data driver 122. Alternatively, the timing controller 121 may provide the image data RGB supplied from the external terminal as is to the data driver 122.

The control signal CON may include a horizontal synchronization signal, a vertical synchronization signal, and a clock signal. The timing controller 121 may generate a horizontal start signal using the horizontal synchronization signal. The timing controller 121 may generate a vertical start signal using the vertical synchronization signal. The timing controller 121 may generate a first clock signal and a second clock signal using the clock signal. The timing controller 121 may provide the vertical start signal and the first clock signal as a first driving signal CTL1 to the scan driver 123. The timing controller 121 may supply the horizontal start signal and the second clock signal as a second driving signal CTL2 to the data driver 122.

The data driver 122 may output the data signal DS in response to the second driving signal CTL2 supplied from the timing controller 121. The data driver 122 may output a gamma voltage corresponding to image data as the data signal DS to a data line in response to the horizontal start signal and the second clock signal.

The scan driver 123 may generate a scan signal SS based on the first driving signal CTL1 supplied from the timing controller 121. The scan driver 123 may generate the scan signal SS in response to the vertical start signal and the first clock signal, and sequentially output the scan signal SS to a scan line.

The display module DM of the head mounted display device HMD may display an image at a position close to the eyes of the user due to a use characteristic, and may generate heat at the position close to the eyes of the user. As the display module DM displays a high-resolution and high-luminance of image, an amount of heat generated from the display module DM may increase. In order to protect the eyes of the user, the head mounted display device HMD may have a heat dissipation structure for effectively releasing the heat generated in the display module DM to the outside.

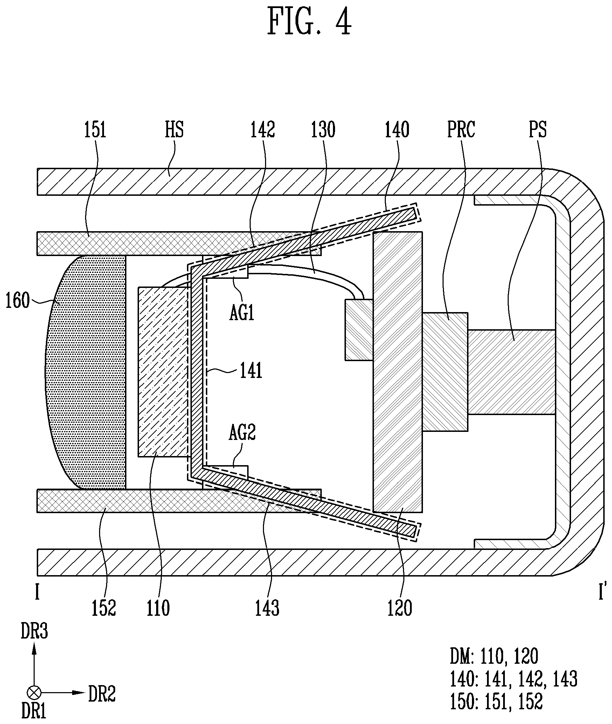

The head mounted display device HMD may have a heat exchanger 140 (refer to FIG. 4) that may effectively release the heat generated in the display module DM outside the display module by convection and radiation. Hereinafter, embodiments of the head mounted display device HMD including the heat exchanger 140 are described in detail.

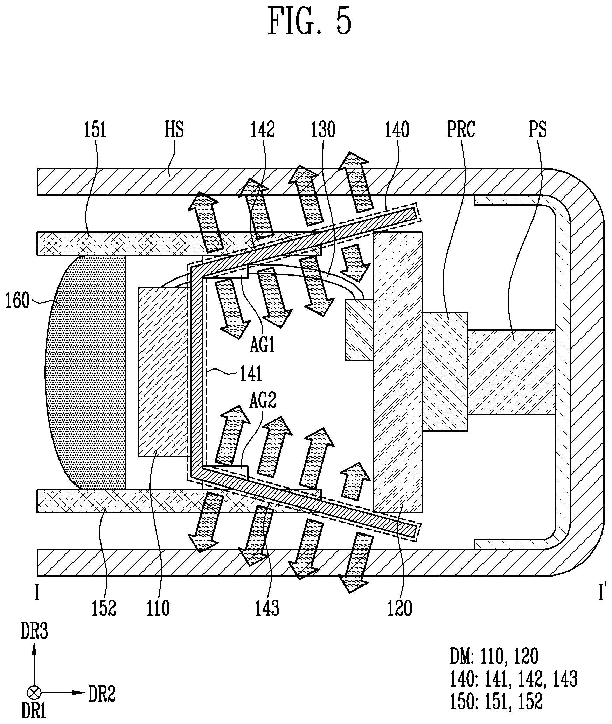

FIG. 4 is a schematic cross-sectional view taken along line I-I' of FIG. 2. FIG. 5 is a drawing illustrating a heat dissipation effect of the head mounted display device of FIG. 4.

Referring to FIG. 4, the head mounted display device HMD may include the display module DM, a connection circuit board 130, a heat exchanger 140, an internal holder 150, a lens 160, the housing HS, the processor PRC, the power supply PS, and the like. The display module DM may include the display panel 110 and the set 120. The heat exchanger 140 may include a center portion 141, a first wing 142, and a second wing 143. The internal holder 150 may include a first internal holder 151 and a second internal holder 152.

A content overlapping the content of the housing HS, the processor PRC, the power supply PS, and the display module DM described with reference to FIGS. 1 to 3 is omitted below.

The housing HS may protect the components (for example, the processor PRC, the display module DM, and the like) from external impact. The housing HS may define an internal space.

The power supply PS may be coupled to the housing HS. The power supply PS may receive external power and internal power and supply power to each of the components (for example, the processor PRC and the display module DM) included in the head mounted display device HMD. The power supply PS may include a battery and may be implemented as a built-in battery or a replaceable battery.

The processor PRC is coupled to the power supply PS. The processor PRC may perform specific calculations or tasks. The processor PRC may control overall operations of the head mounted display device HMD.

The set 120 of the display module DM may be coupled to the processor PRC. The set 120 may control the display panel 110 so that the display panel 110 may display an image. For example, the set 120 may receive the image data RGB and the control signal CON provided from the processor PRC. In addition, the set 120 may provide the data signal DS and the scan signal SS generated based on the received signals to the display panel 110 through the connection circuit board 130, to display an image.

The connection circuit board 130 may electrically connect the display panel 110 and the set 120. The connection circuit board 130 may receive the data signal DS and the scan signal SS from the set 120. In addition, the connection circuit board 130 may transmit the data signal DS and the scan signal SS to the display panel 110.

The connection circuit board 130 may include a flexible material. The connection circuit board 130 may be bent at a predetermined curvature, one side of the connection circuit board 130 may be connected to the display panel 110, and another side of the connection circuit board 130 may be connected to the set 120.

The heat exchanger 140 may be coupled on a back surface of the display panel 110. More specifically, as shown in FIG. 4, the back surface of the display panel 110 may be attached to the center portion 141 of the heat exchanger 140. However, embodiments are not necessarily limited thereto and may vary according to the shape of the internal space of the head mounted display device HMD. For example, the back surface of the display panel 110 may be coupled to the first wing 142 of the heat exchanger 140. For example, the back surface of the display panel 110 may be attached to the second wing 143 of the heat exchanger 140.

The heat exchanger 140 may include metals having high thermal conductivity. However, it is not necessarily limited thereto, and the heat exchanger 140 may include non-metals having high thermal conductivity.

The first wing 142 may extend from the center portion 141 and may be bent from the center portion 141 by a first angle AG1. The second wing 143 may extend from the center portion 141 and may be bent from the center portion 141 by a second angle AG2. The first angle AG1 and the second angle AG2 may be substantially the same. However, the first angle AG1 and the second angle AG2 may be different from each other.

The heat exchanger 140 may further include additional wings extending from the center portion 141 and bent from the center portion 141.

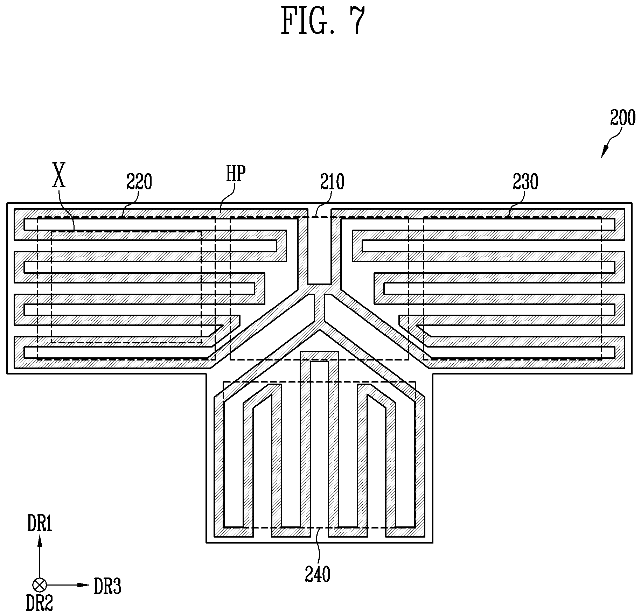

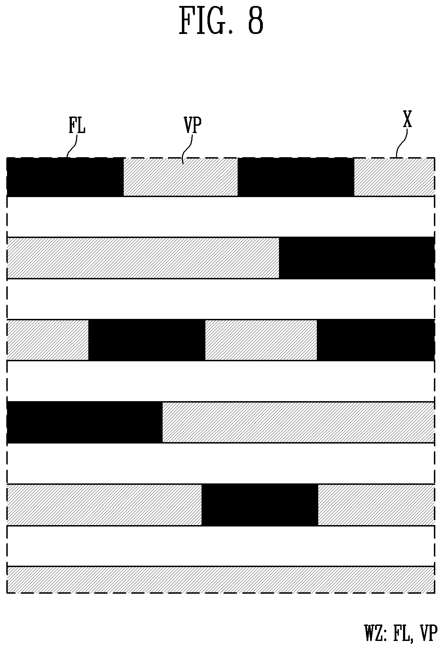

Referring to FIG. 5, heat emitted from the display panel 110 may be transferred to the center portion 141. In addition, the transferred heat may move to the first wing 142 and the second wing 143 and may be released to the outside in the form of convection and radiation (as shown by the arrows). More specifically, the transferred heat may be released to the outside in the form of convection and radiation by using a working fluid WZ (refer to FIG. 8) included in a heat pipe HP (refer to FIG. 7) inside the heat exchanger 140. This is described in detail with reference to FIGS. 7 to 9.

Embodiments may efficiently release the heat generated from the display panel 110 to the outside by including the heat exchanger 140. The heat exchanger 140 may include one or more additional wings in addition to the first wing 142 and the second wing 143. As the number of wings extending from the center portion 141 increases, heat dissipation effect of the heat exchanger 140 may increase.

The display panel 110 may be attached to the heat exchanger 140. The back surface of the display panel 110 may be attached to the heat exchanger 140, and a front surface facing the back surface of the display panel 110 may display an image. For example, the display panel 110 may display an image in a direction opposite to a second direction DR2.

The lens 160 may adjust the image displayed from the display panel 110. In addition, the adjusted image may face the eyes of the user. Although the lens 160 is shown as a convex lens in FIG. 5, it is not necessarily limited thereto. For example, the lens 160 may be a concave lens.

The heat exchanger 140, the display panel 110, and the lens 160 may be supported by the internal holder 150. The first internal holder 151 and the second internal holder 152 may be spaced apart in a third direction DR3, and the display panel 110 and the lens 160 may be disposed between the first internal holder 151 and the second internal holder 152.

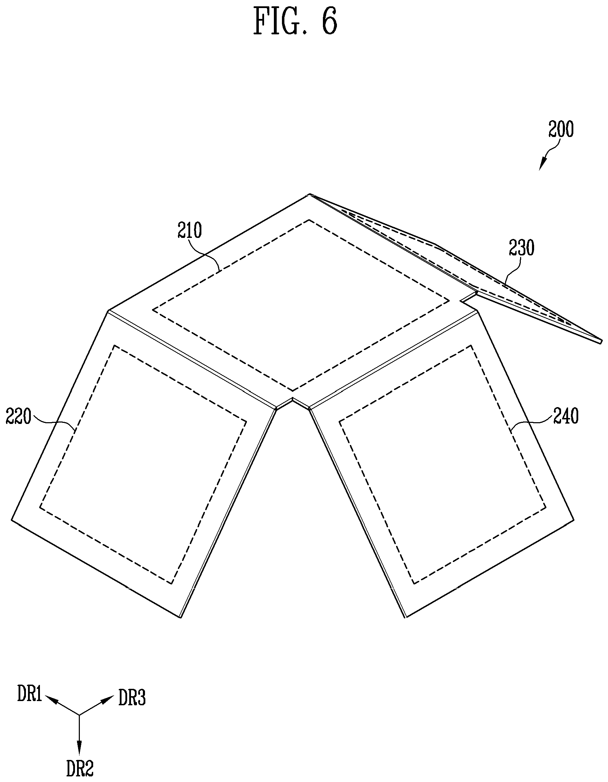

FIG. 6 is a perspective view illustrating the heat exchanger of FIG. 4. FIG. 7 is an un-folded plan view illustrating an internal configuration of the heat exchanger of FIG. 6. For convenience of description and as used herein, an "un-folded plan view" shows wings extending from a center portion of the heat exchanger in which the wings have been un-folded to show them as being in the plane of the center portion of the heat exchanger.

Referring to FIGS. 6 and 7, the heat exchanger 200 may include a plurality of wings. In Figs. 6 and 7, the heat exchanger 200 includes three wings extending from a center portion 210 and bent from the center portion 210.

The heat exchanger 200 may include the center portion 210, a first wing 220, a second wing 230, and a third wing 240.

The heat exchanger 200 may have a three-dimensional shape that extends in first to third directions DR1 to DR3. The heat exchanger 200 may form an internal space.

The first, second, and third wings 220, 230, and 240 may respectively extend from different edges of the center portion 210. For example, as shown in FIG. 6, the first, second, and third wings 220, 230, and 240 may respectively extend from different edges among four edges of the center portion 210. As used herein, an "edge" of the center portion from which a wing extends means an imaginary plane at an intersection of the center portion and a wing.

Each of the first, second, and third wings 220, 230, and 240 may be bent from the center portion 210 to be efficiently disposed in an internal space of the head mounted display device HMD. However, the first, second, and third wings 220, 230, and 240 may not be bent from the center portion 210.

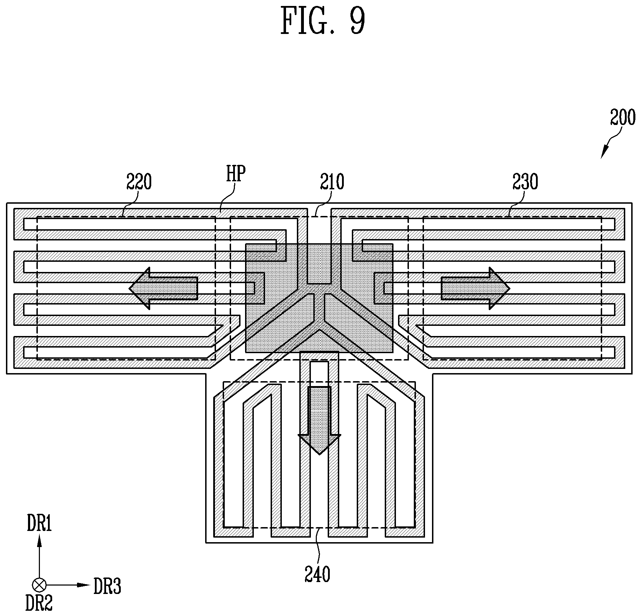

A heat pipe HP may be disposed inside the heat exchanger 200. The heat pipe HP may have a three-dimensional shape such as a cylinder. In addition, the heat pipe HP may form an internal space. A working fluid WZ (refer to FIG. 8) may be included in the heat pipe HP. The heat exchanger 200 may receive heat emitted from the display panel 110 and release the heat to the outside using the working fluid WZ. This is described in detail later with reference to FIG. 9.

The heat pipe HP may be disposed throughout the internal space of the center portion 210, the first wing 220, the second wing 230, and the third wing 240. In addition, the heat pipes HP disposed inside the heat exchanger 200 may be connected to each other to form one closed loop. The working fluid WZ included in the heat pipe HP may move along the heat pipe HP throughout the entire area of the heat exchanger 200. For example, the working fluid WZ included in the heat pipe HP disposed in the internal space of the center portion 210 may move to the heat pipe HP disposed in the internal space of the first wing 220. For example, the working fluid WZ included in the heat pipe HP disposed in the internal space of the center portion 210 may move to the heat pipe HP disposed in the internal space of the second wing 230. For example, the working fluid WZ included in the heat pipe HP disposed in the internal space of the center portion 210 may move to the heat pipe HP disposed in the internal space of the third wing 240.

FIG. 8 is an enlarged view of a portion X of FIG. 7.

Referring to FIGS. 7 and 8, the working fluid WZ may be included in the heat pipe HP. The working fluid WZ may include a liquid FL and an air layer VP.

A volume of the air layer VP (or a volume of the liquid FL) in the working fluid WZ may be freely designed according by a person having ordinary skill in the art within a range that may move the liquid FL through a capillary phenomenon. For example, the volume of the liquid FL in the working fluid WZ may be about 20% or more and 50% or less.

The liquid FL may include at least one of water, freon, methanol, and ethanol.

The volume of the air layer VP may be increased in a high temperature area and may be decreased in a low temperature area. When the volume of the air layer VP is increased in the high temperature area, the air layer VP may push the liquid FL. The liquid FL pushed by the air layer VP in the high temperature area may move to the low temperature area. In the low temperature area, the liquid FL releases heat. Accordingly, a heat dissipation function may be performed in the heat exchanger 200. A specific heat dissipation effect is described in detail later with reference to FIG. 9.

FIG. 9 is a drawing illustrating the heat dissipation effect of the heat exchanger of FIG. 7.

Referring to FIG. 9, the back surface of the display panel 110 may be attached to the center portion 210. However, the back surface of the display panel 110 may be attached to one of the first, second, and third wings 220, 230, and 240. Hereinafter, the disclosure is described on the assumption that the back surface of the display panel 110 is attached to the center portion 210.

While the display panel 110 displays an image, heat may be generated by the display panel 110. The generated heat may be transferred to the center portion 210 that is in contact with the display panel 110. Here, the center portion 210 may correspond to the high-temperature area described with reference to FIG. 8. The first, second, and third wings 220, 230, and 240 may correspond to the lower temperature area described with reference to FIG. 8.

The volume of the air layer VP included in the heat pipe HP disposed in the internal space of the center portion 210 may be increased due to the heat transferred from the display panel 110. When the volume of the air layer VP is increased, the air layer VP may push the liquid FL. The liquid FL pushed by the air layer VP in the high temperature area may be directed to the first, second, and third wings 220, 230, and 240 flow along the heat pipe HP. In other words, the liquid FL pushed by the air layer VP in the high temperature area may move to the low temperature area along the heat pipe HP. The liquid FL releases heat in the low temperature area. Accordingly, the heat dissipation function may be performed in the heat exchanger 200.

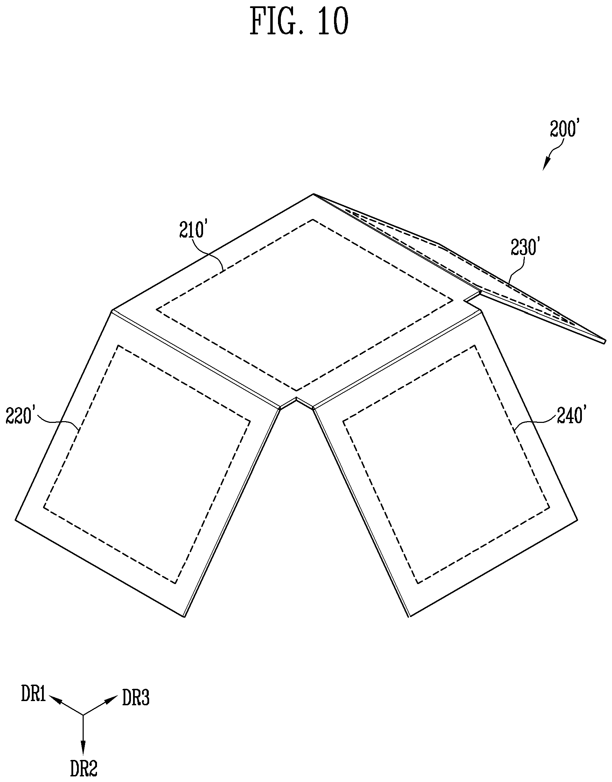

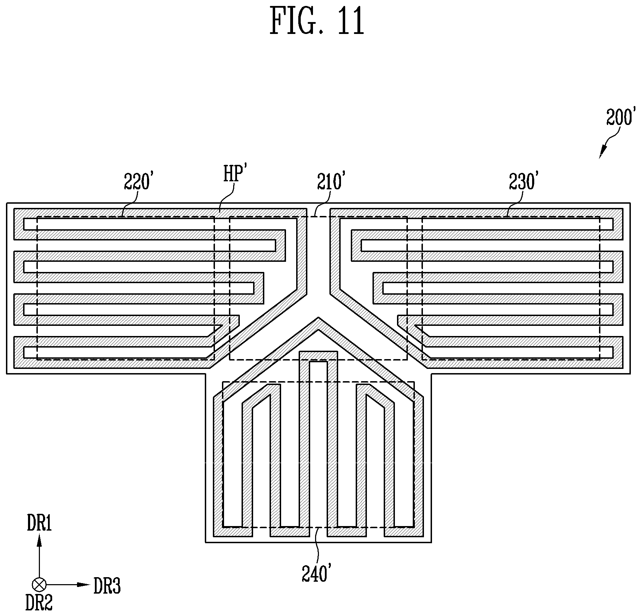

FIG. 10 is a perspective view illustrating the heat exchanger of FIG. 4. FIG. 11 is an un-folded plan view illustrating an internal configuration of the heat exchanger of FIG. 10.

Referring to FIGS. 10 and 11, the heat exchanger 200' may include a plurality of wings. In FIGS 10 and 11, the heat exchanger 200' includes three wings extending from a center portion 210' and bent from the center portion 210'.

The heat exchanger 200' may include the center portion 210', a first wing 220', a second wing 230', and a third wing 240'.

The heat exchanger 200' may have a three-dimensional shape extending in the first to third directions DR1 to DR3. The heat exchanger 200' may form an internal space.

The first, second, and third wings 220', 230', and 240' may respectively extend from different edges of the center portion 210'. For example, as shown in FIG. 10, the first, second, and third wings 220', 230', and 240' may respectively extend from different edges among four edges of the center portion 210'.

Each of the first, second, and third wings 220', 230', and 240' may be respectively bent from the center portion 210' to be efficiently disposed in an internal space of the head mounted display device HMD. However, each of the first, second, and third wings 220', 230', and 240' may not be bent from the center portion 210'.

A heat pipe HP' may be disposed inside the heat exchanger 200'. The heat pipe HP' may have a three-dimensional shape such as a cylinder. In addition, the heat pipe HP' may form an internal space. The working fluid WZ (refer to FIG. 8) may be included in the heat pipe HP'. The heat exchanger 200' may receive the heat emitted from the display panel 110 and release the heat to the outside using the working fluid WZ.

The heat pipe HP' may be disposed throughout the internal space of the center portion 210', the first wing 220', the second wing 230', and the third wing 240'. In addition, the heat pipe HP' disposed inside the heat exchanger 200' may be separated from each other to form a plurality of closed loops. More specifically, the heat pipe HP' disposed in the internal space of each of the first wing 220', the second wing 230', and the third wing 240' may be separated from each other to form a separate closed loop. For example, the heat pipe HP' may form one closed loop throughout the first wing 220' and the center portion 210'. For example, the heat pipe HP' may form one closed loop throughout the second wing 230' and the center portion 210'. For example, the heat pipe HP' may form one closed loop throughout the third wing 240' and the center portion 210'.

The working fluid WZ may be individually injected into each of the separate closed loops. Accordingly, volumes of the liquid FL in the working fluid WZ included in each of the separate closed loops may be different from each other. A working fluid WZ of which the volume of the liquid FL is high may be injected into a wing that is intended to perform a greater heat dissipation function among the first, second, and third wings 220', 230', and 240'. However, embodiments are not necessarily limited thereto. For example, the volume of the liquid FL in the working fluid WZ included in each of the above-described separate closed loops may be substantially the same.

Some of the working fluid WZ included in the heat pipe HP disposed in the internal space of the center portion 210' may move to the heat pipe HP' disposed in the internal space of the first wing 220'. Some of the working fluid WZ included in the heat pipe HP' disposed in the internal space of the center portion 210' may move to the heat pipe HP' disposed in the internal space of the second wing 230'. Some of the working fluid WZ included in the heat pipe HP' disposed in the internal space of the center portion 210' may move to the heat pipe HP' disposed in the internal space of the third wing 240'.

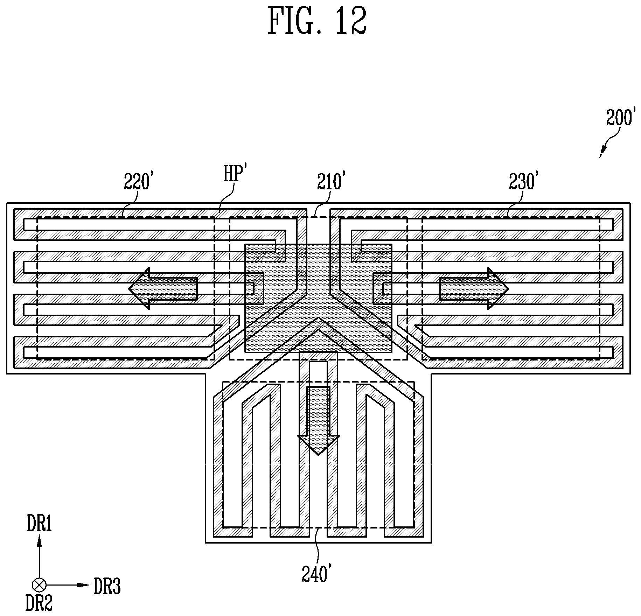

FIG. 12 is a drawing illustrating a heat dissipation effect of the heat exchanger of FIG. 11.

Referring to FIG. 12, the back surface of the display panel 110 may be attached to the center portion 210'. However, the back surface of the display panel 110 may be attached to one of the first, second, and third wings 220', 230', and 240'. Hereinafter, the disclosure is described on the assumption that the back surface of the display panel 110 is coupled on the center portion 210'.

While the display panel 110 displays an image, heat may be generated from the display panel 110. The generated heat may be transferred to the center portion 210' that is in contact with the display panel 110. Here, the center portion 210' may correspond to the high temperature area described with reference to FIG. 8. The first, second, and third wings 220', 230', and 240' may correspond to the lower temperature area described with reference to FIG. 8.

The volume of the air layer VP included in the heat pipe HP' disposed in the internal space of the center portion 210' may be increased due to the heat transferred from the display panel 110. When the volume of the air layer VP is increased, the air layer VP may push the liquid FL. The liquid FL pushed by the air layer VP in the high temperature area may be directed to the first, second, and third wings 220', 230', and 240' along the heat pipe HP. In other words, the liquid FL pushed by the air layer VP in the high temperature area may move to the low temperature area along the heat pipe HP. The liquid FL releases heat in the low temperature area. Accordingly, a heat dissipation function may be performed in the heat exchanger 200'.

The volumes of the liquid FL in the working fluid WZ included in each of the separate closed loops may be different from each other. For example, a case where the heat pipe HP' disposed in the internal space of the twenty-second' wing 220' includes the working fluid WZ having a high volume of the liquid FL. In this case, a heat dissipation effect in the twenty-second' wing 220' may be greater than a heat dissipation effect in the other wings.

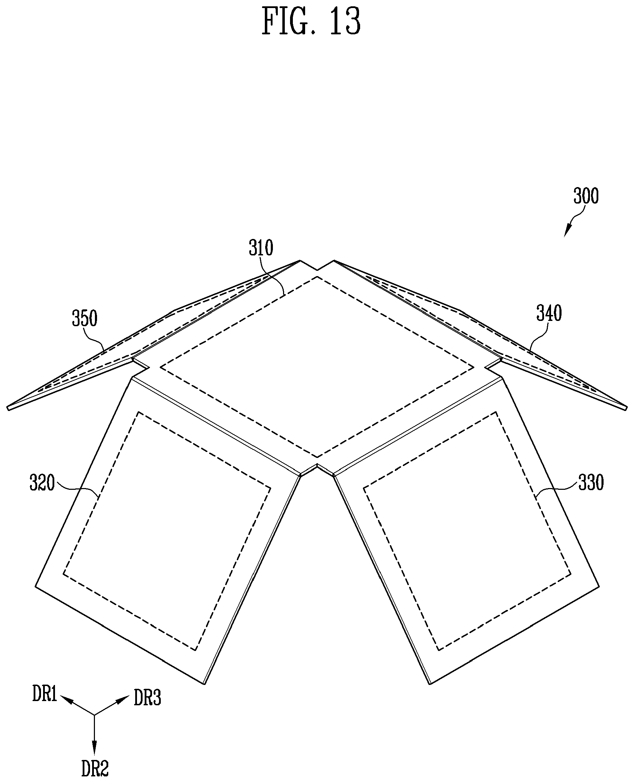

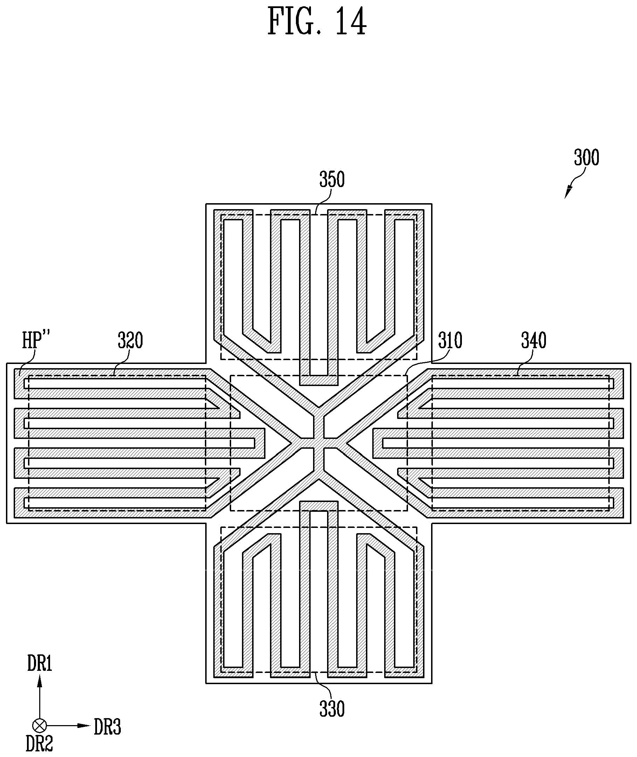

FIG. 13 is a perspective view illustrating the heat exchanger of FIG. 4. FIG. 14 is an un-folded plan view illustrating an internal configuration of the heat exchanger of FIG. 13.

Referring to FIGS. 13 and 14, the heat exchanger 300 may include a plurality of wings. In FIGS. 13 and 14, the heat exchanger 300 includes four wings extending from a center portion 310 and bent from the center portion 310.

The heat exchanger 300 may include the center portion 310, a first wing 320, a second wing 330, a third wing 340, and a fourth wing 350.

The heat exchanger 300 may have a three-dimensional shape extending in the first to third directions DR1 to DR3. The heat exchanger 300 may form an internal space.

The first, second, third, and fourth wings 320, 330, 340, and 350 may respectively extend from different edges of the center portion 310. For example, as shown in FIG. 13, the first, second, third, and fourth wings 320, 330, 340, and 350 may respectively extend from different edges among the four edges of the center portion 310.

The first, second, third, and fourth wings 320, 330, 340, and 350 may be bent from the center portion 310 to be efficiently disposed in the internal space of the head mounted display device HMD. However, each of the first, second, third, and fourth wings 320, 330, 340, and 350 may not be bent from the center portion 310.

A heat pipe HP" may be disposed inside the heat exchanger 300. The heat pipe HP" may have a three-dimensional shape such as a cylinder. In addition, the heat pipe HP" may form an internal space. The working fluid WZ (refer to FIG. 8) may be included in the heat pipe HP". The heat exchanger 300 may receive heat emitted from the display panel 110 and release the heat to the outside using the working fluid WZ.

The heat pipe HP" may be disposed throughout an internal space of the center portion 310, the first wing 320, the second wing 330, the third wing 340, and the fourth wing 350. In addition the heat pipes HP" disposed inside the heat exchanger 300 may be connected to each other to form a closed loop. The working fluid WZ included in the heat pipe HP" may move along the heat pipe HP" throughout the entire area of the heat exchanger 300. For example, the working fluid WZ included in the heat pipe HP" disposed in the internal space of the center portion 310 may move to the heat pipe HP" disposed in the internal space of the first wing 320. For example, the working fluid WZ included in the heat pipe HP" disposed in the internal space of the center portion 310 may move to the heat pipe HP" disposed in the internal space of the second wing 330. For example, the working fluid WZ included in the heat pipe HP" disposed in the internal space of the center portion 310 may move to the heat pipe HP" disposed in the internal space of the third wing 340. For example, the working fluid WZ included in the heat pipe HP" disposed in the internal space of the center portion 310 may move to the heat pipe HP" disposed in the internal space of the fourth wing 350.

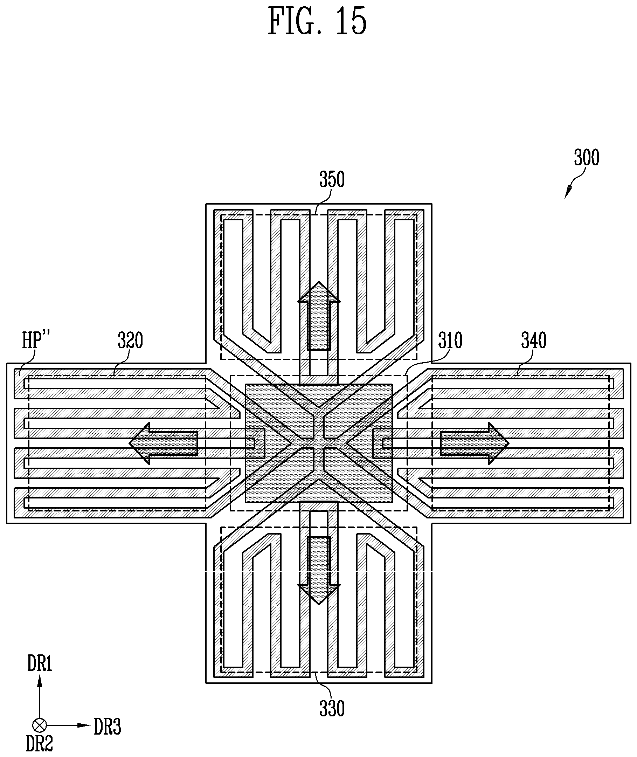

FIG. 15 is a drawing illustrating a heat dissipation effect of the heat exchanger of FIG. 14.

Referring to FIG. 15, the back surface of the display panel 110 may be attached to the center portion 310. However, the back surface of the display panel 110 may be attached to one of the first, second, third, and fourth wings 320, 330, 340, and 350. Hereinafter, the disclosure is described on the assumption that the back surface of the display panel 110 is attached to the center portion 310.

While the display panel 110 displays an image, heat may be generated from the display panel 110. The generated heat may be transferred to the center portion 310 that is in contact with the display panel 110. Here, the center portion 310 may correspond to the high temperature area described with reference to FIG. 8. The first, second, third, and fourth wings 320, 330, 340, and 350 may correspond to the lower temperature area described with reference to FIG. 8.

The volume of the air layer VP included in the heat pipe HP" disposed in the internal space of the center portion 310 may be increased due to the heat transferred from the display panel 110. When the volume of the air layer VP is increased, the air layer VP may push the liquid FL. The liquid FL pushed by the air layer VP in the high temperature area may be directed to the first, second, third, and fourth wings 320, 330, 340, and 350 along the heat pipe HP". In other words, the liquid FL pushed by the air layer VP in the high temperature area may move to the low temperature area along the heat pipe HP". In the low temperature area, the liquid FL releases heat. Accordingly, a heat dissipation function may be performed in the heat exchanger 300.

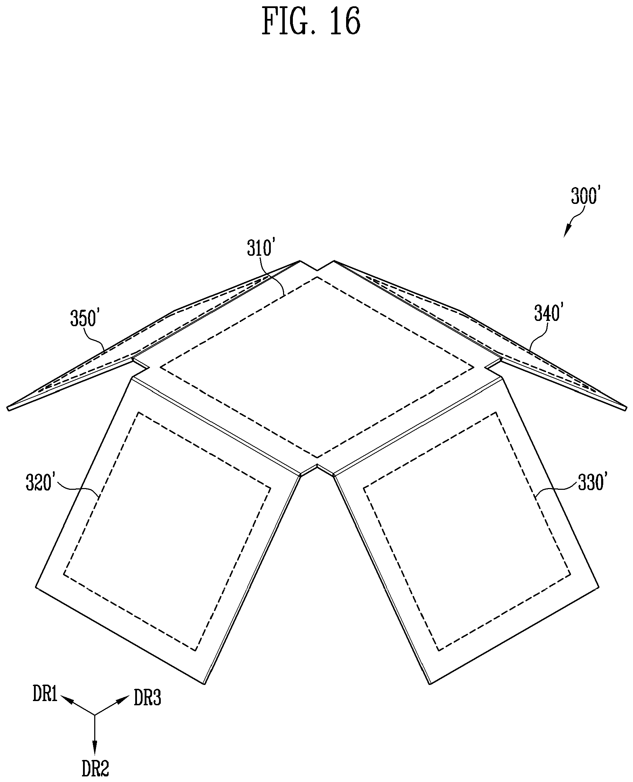

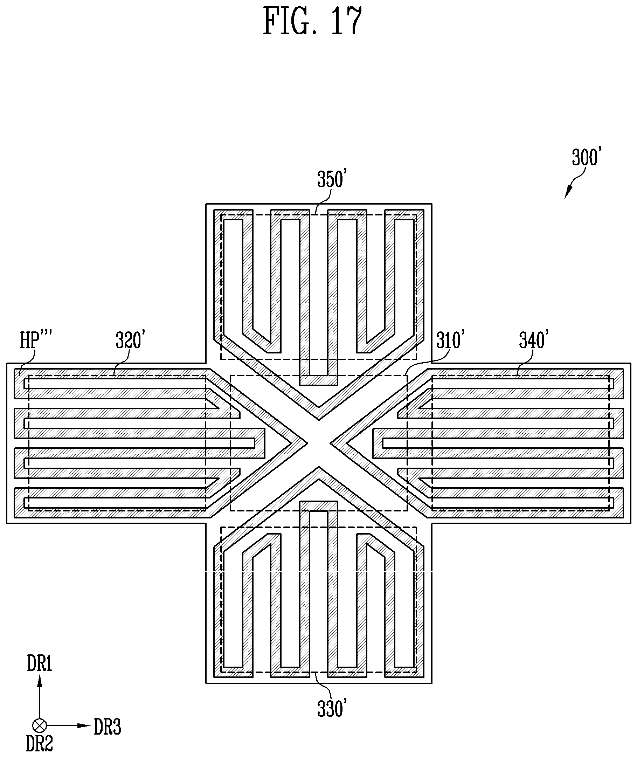

FIG. 16 is a perspective view illustrating the heat exchanger of FIG. 4. FIG. 17 is an un-folded plan view illustrating an internal configuration of the heat exchanger of FIG. 16.

Referring to FIGS. 16 and 17, the heat exchanger 300' may include a plurality of wings. In FIGS. 16 and 17, the heat exchanger 300' includes four wings extending from a center portion 310' and bent from the center portion 310'.

The heat exchanger 300' may include the center portion 310', a first wing 320', a second wing 330', a third wing 340', and a fourth wing 350'.

The heat exchanger 300' may have a three-dimensional shape extending in the first to third directions DR1 to DR3. The heat exchanger 300' may form an internal space.

The first, second, third, and fourth wings 320', 330', 340', and 350' may respectively extend from different edges of the center portion 310'. For example, as shown in FIG. 16, the first, second, third, and fourth wings 320', 330', 340', and 350' may respectively extend from different edges among four side edges of the center portion 310'.

Each of the first, second, third, and fourth wings 320', 330', 340', and 350' may be bent from the center portion 310' to be efficiently disposed in the internal space of the head mounted display device HMD. However, each of the first, second, third, and fourth wings 320', 330', 340', and 350' may not be bent from the center portion 310'.

A heat pipe HP‴ may be disposed inside the heat exchanger 300'. The heat pipe HP‴ may have a three-dimensional shape such as a cylinder. In addition, the heat pipe HP‴ may form an internal space. The working fluid WZ (refer to FIG. 8) may be included in the heat pipe HP"'. The heat exchanger 300' may receive heat emitted from the display panel 110 and release the heat to the outside using the working fluid WZ.

The heat pipes HP‴ may be disposed throughout an internal space of the center portion 310', the first wing 320', the second wing 330', the third wing 340', and the fourth wing 350'. In addition, the heat pipes HP‴ disposed inside the heat exchanger 300' may be separated from each other to form a plurality of closed loops. More specifically, the heat pipes HP‴ disposed in the internal spaces of each of the first wing 320', the second wing 330', the third wing 340', and the fourth wing 350' may be separated from each other to form separate closed loops. For example, the heat pipe HP‴ may form one closed loop throughout the first wing 320' and the center portion 310'. For example, the heat pipe HP‴ may form one closed loop throughout the second wing 330' and the center portion 310'. For example, the heat pipe HP"' may form one closed loop throughout the third wing 340' and the center portion 310'. For example, the heat pipe HP‴ may form one closed loop throughout the fourth wing 350' and the center portion 310'.

The working fluid WZ may be individually injected into each of the separate closed loops. Accordingly, the volumes of the liquid FL in the working fluid WZ included in each of the separate closed loops may be different from each other. A working fluid WZ of which the volume of the liquid FL is high may be injected into a wing that is intended to perform a greater heat dissipation function among the first, second, third, and fourth wings 320', 330', 340', and 350'. However, embodiments are not limited thereto. For example, the volume of the liquid FL in the working fluid WZ included in each of the separate closed loops may be substantially the same.

Some of the working fluid WZ included in the heat pipe HP‴ disposed in the internal space of the center portion 310' may move to the heat pipe HP‴ disposed in the internal space of the first wing 320'. Some of the working fluid WZ included in the heat pipe HP"' disposed in the internal space of the center portion 310' may move to the heat pipe HP"' disposed in the internal space of the second wing 330'. Some of the working fluid WZ included in the heat pipe HP‴ disposed in the internal space of the center portion 310' may move to the heat pipe HP"' disposed in the internal space of the third wing 340'. Some of the working fluid WZ included in the heat pipe HP‴ disposed in the internal space of the center portion 310' may move to the heat pipe HP"' disposed in the internal space of the third-fifth' wing 350'.

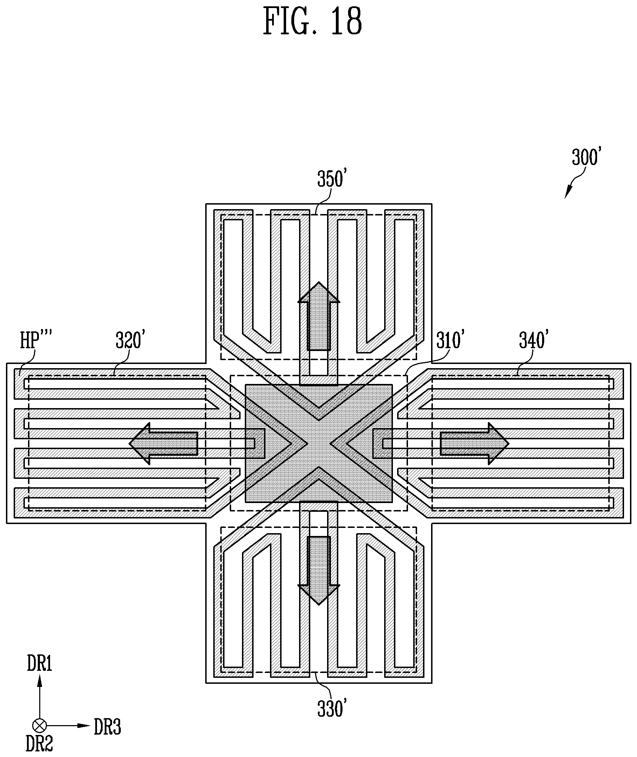

FIG. 18 is a drawing illustrating a heat dissipation effect of the heat exchanger of Fig. 17.

Referring to FIG. 18, the back surface of the display panel 110 may be attached to the center portion 310'. However, the back surface of the display panel 110 may be attached to one of the first, second, third, and fourth wings 320', 330', 340', and 350'. Hereinafter, the disclosure is described on the assumption that the back surface of the display panel 110 is attached to the center portion 310'.

While the display panel 110 displays an image, heat may be generated from the display panel 110. The generated heat may be transferred to the center portion 310' that is in contact with the display panel 110. Here, the center portion 310' may correspond to the high temperature area described with reference to FIG. 8. In contrast, the first, second, third, and fourth wings 320', 330', 340', and 350' may correspond to the lower temperature area described with reference to FIG. 8.

The volume of the air layer VP included in the heat pipe HP"' disposed in the internal space of the center portion 310' may be increased due to the heat transferred from the display panel 110. When the volume of the air layer VP is increased, the air layer VP may push the liquid FL. The liquid FL pushed by the air layer VP in the high temperature area may be directed to the first, second, third, and fourth wings 320', 330', 340', and 350' along the heat pipe HP‴. In other words, the liquid FL pushed by the air layer VP in the high temperature area may move to the low temperature area along the heat pipe HP". In the low temperature area, the liquid FL releases the heat. Accordingly, a heat dissipation function may be performed in the heat exchanger 300'.

The heat exchanger according to embodiments has a simple structure including a center portion and a plurality of wings extending from the center portion. In addition, the plurality of wings may be bent from the center portion at a certain angle, thereby securing spatial efficiency in the head mounted display device HMD. An internal space of the heat exchanger may include a heat pipe and a working fluid. Heat generated from the display panel 110 may be efficiently released to the outside, by using the heat pipe and the working fluid.

While the present disclosure has been described with reference to embodiments thereof, it will be apparent to those of ordinary skill in the art that various changes and modifications may be made thereto without departing from the scope of the invention as set forth in the following claims.

## Claims

1. A head mounted display device comprising:
a display panel; and
a heat exchanger attached to a back surface of the display panel to transfer heat away from the display panel,
wherein the heat exchanger comprises:
a center portion; and
a plurality of wings bent from the center portion.

2. The head mounted display device according to claim 1, wherein an internal space of the center portion and the plurality of wings comprises:
one or more heat pipes; and
a working fluid within the heat pipes that, in operation, transfers heat away from the display panel.

3. The head mounted display device according to claim 2, wherein the working fluid includes a liquid and an air layer.

4. The head mounted display device according to claim 3, wherein the volume of the liquid in the working fluid is 20% or more and 50% or less.

5. The head mounted display device according to claim 2, 3 or 4, wherein the heat exchanger includes three wings bent from the center portion, and the three wings extend from different edges of the center portion, respectively.

6. The head mounted display device according to claim 5, wherein heat pipes disposed in the internal space of the center portion and the three wings are connected to each other to form a loop.

7. The head mounted display device according to claim 5, wherein heat pipes disposed in the internal space of each of the three wings are separated from each other to form separate closed loops.

8. The head mounted display device according to claim 2, 3 or 4, wherein the heat exchanger includes four wings bent from the center portion, and the four wings extend from different edges of the center portion, respectively.

9. The head mounted display device according to claim 8, wherein heat pipes disposed in the internal space of the center portion and the four wings are connected to each other to form a closed loop.

10. The head mounted display device according to claim 8, wherein heat pipes disposed in the internal space of each of the four wings are separated from each other to form separate closed loops.
